# EUROPEAN PATENT APPLICATION

(11) **EP 3 839 986 A1**
(43) Date of publication of application: **23.06.2021**
(21) Application number: 20213571.1
(22) Date of filing: 11.12.2020
(51) Int. Cl.: H01F 1/37, H05K 3/42

(54) **MAGNETIC PASTE**

(30) Priority: 16.12.2019 JP 2019226740
(71) Applicant: AJINOMOTO CO., INC., Chuo-ku Tokyo 104-8315 (JP)
(72) Inventor: TANAKA, Takayuki, Kawasaki-shi, Kanagawa 210-0801 (JP)
(74) Representative: Mewburn Ellis LLP

(57) **Abstract**

Provided is a magnetic paste including: magnetic powder (A); an epoxy resin (B); a reactive diluent (C); and a curing agent (D), in which the reactive diluent (C) contains a tri- or higher functional reactive diluent.

## Description

### BACKGROUND OF THE INVENTION

### 1. Field of the Invention

The present invention relates to a magnetic paste, and a circuit board and an inductor substrate obtained by using the magnetic paste, and a method for manufacturing the circuit board.

### 2. Description of the Related Art

In recent years, with demands for reductions in the size and thickness of electronic devices, reductions in the size and thickness of a printed wiring board and an inductor component (coil) to be mounted on the printed wiring board have been also required. When an inductor component is mounted as a chip component, there is a limit to thickness reduction of a printed wiring board. Therefore, a proposal has been made that an inductor is formed in an inner layer of a printed wiring board by forming a magnetic layer in a printed circuit board by the use of an adhesive film containing a magnetic material in a resin composition layer (for example, see Japanese Patent Application Laid-open No. 2015-187260).

### SUMMARY OF THE INVENTION

The inventors found that, when wet desmearing is performed at the time of forming a conductive layer on a magnetic layer by the use of magnetic paste or when wet desmearing is performed in order to remove a smear generated by polishing a magnetic layer, the roughened form of a surface of the magnetic layer is deteriorated (in other words, the desmear resistance thereof becomes inferior) due to the peeling off or dissolution of resin components by an oxidant solution. Due to this deterioration, even when a conductive layer, such as metal plating, is formed on the magnetic layer, a blister tends to develop in the conductive layer and adhesion between the magnetic layer and the conductive layer tends to decrease.

The present invention has been made in view of the circumstances described above, and an object of the present invention is to provide a magnetic paste capable of achieving a cured product having enhanced desmear resistance and enhanced adhesion between a magnetic layer and a conductive layer, and a circuit board and an inductor substrate obtained by using the magnetic paste, and a method for manufacturing the circuit board.

### Means for Solving the Problem

The inventors carried out intensive studies and found that a magnetic paste containing a tri- or higher functional reactive diluent as a reactive diluent allowed desmear resistance and adhesion between a magnetic layer and a conductive layer to be enhanced, and thus the present invention was completed.

Namely, the present invention includes following contents.
[1] A magnetic paste comprising:
   magnetic powder (A);
   an epoxy resin (B);
   a reactive diluent (C); and
   a curing agent (D), wherein
   the reactive diluent (C) includes a tri- or higher functional reactive diluent.
[2] The magnetic paste according to [1], wherein a content of the tri- or higher functional reactive diluent is 0.5% by mass or higher and 10% by mass or lower, with respect to 100% by mass of non-volatile components in the magnetic paste.
[3] The magnetic paste according to [1] or [2], wherein a content of the tri- or higher functional reactive diluent is 20% by mass or higher, with respect to 100% by mass of an entirety of the reactive diluent (C).
[4] The magnetic paste according to any one of [1] to [3], wherein the magnetic powder (A) is soft magnetic powder.
[5] The magnetic paste according to any one of [1] to [4], wherein the magnetic powder (A) is iron oxide powder.
[6] The magnetic paste according to [5], wherein the iron oxide powder is ferrite containing at least one selected from Ni, Cu, Mn, and Zn.
[7] The magnetic paste according to any one of [1] to [6], wherein the magnetic powder (A) is at least one selected from Fe-Mn-based ferrite and Fe-Mn-Zn-based ferrite.
[8] The magnetic paste according to any one of [1] to [7], wherein a content of the magnetic powder (A) is 60% by mass or higher with respect to 100% by mass of non-volatile components in the magnetic paste.
[9] The magnetic paste according to any one of [1] to [8], the magnetic paste is for through-hole filling.
[10] A circuit board comprising a substrate having a through-hole filled with a cured product of the magnetic paste according to any one of [1] to [9].
[11] An inductor component comprising the circuit board according to [10].
[12] A method for manufacturing a circuit board, the method comprising:
   (1) filling a through-hole with a magnetic paste and thermally curing the magnetic paste to obtain a cured product;
   (2) polishing a surface of the cured product;
   (3) desmearing the polished surface of the cured product; and
   (4) forming a conductive layer in the polished surface of the cured product, wherein
   the magnetic paste is the magnetic paste according to any one of [1] to [9].

### Advantageous Effects of Invention

According to the present invention, there can be provided a magnetic paste capable of achieving a cured product having enhanced desmear resistance and enhanced adhesion between a magnetic layer and a conductive layer, and a circuit board and an inductor substrate obtained by using the magnetic paste, and a method for manufacturing the circuit board.

### BRIEF DESCRIPTION OF THE DRAWINGS

FIG. 1 is a schematic cross-sectional view of a core substrate as an example;
FIG. 2 is a schematic cross-sectional view of the core substrate having a through-hole formed therein, as an example;
FIG. 3 is a schematic cross-sectional view illustrating a state in which the through-hole is filled with a magnetic paste, as an example;
FIG. 4 is a schematic cross-sectional view illustrating a state of a cured product of the magnetic paste that is obtained by thermally curing the filling magnetic paste, as an example; and
FIG. 5 is a schematic cross-sectional view illustrating a state of the cured product of the magnetic paste after polishing, as an example.

### DETAILED DESCRIPTION OF THE PREFERRED EMBODIMENTS

Hereinafter, embodiments of the present invention will be described with reference to the drawings. Note that the drawings just schematically illustrate the shape, size, and arrangement of constituents to the extent of aiding the understanding of the invention. The present invention is not limited by the following embodiments, and constituents may be suitably changed. Configurations according to the embodiments of the present invention are not necessarily produced or used in accordance with the illustrated arrangement examples.

### Magnetic paste

A magnetic paste of the present invention contains magnetic powder (A), an epoxy resin (B), a reactive diluent (C), and a curing agent (D), in which the component (C) includes a tri- or higher functional reactive diluent.

In the present invention, the magnetic paste contains a tri- or higher functional reactive diluent as the component (C), whereby a magnetic layer can have enhanced desmear resistance. When the desmear resistance of the magnetic layer is enhanced, adhesion between the magnetic layer and a conductive layer can be enhanced. Furthermore, a cured product of this magnetic paste can usually have an enhanced relative magnetic permeability at a frequency of 10 to 200 MHz and lower magnetic-loss.

The magnetic paste may further contain a dispersant (E) and other additives (F), if needed. Hereinafter, the components contained in the magnetic paste of the present invention will be described in detail.

### Magnetic powder (A)

The magnetic paste contains a magnetic powder (A) as the component (A). When the magnetic paste contains the magnetic powder (A), a cured product of the magnetic paste can have an enhanced relative magnetic permeability. The magnetic powder (A) may be used alone or two or more kinds thereof may be used in combination.

Although the magnetic powder (A) may be either soft magnetic powder or hard magnetic powder, the magnetic powder (A) is preferably soft magnetic powder from the viewpoint of remarkably achieving the effects of the present invention.

Examples of the magnetic powder (A) include iron oxide powder, such as Fe-Mn-based ferrite, Fe-Mn-Zn-based ferrite, Mg-Zn-based ferrite, Mn-Zn-based ferrite, Mn-Mg-based ferrite, Cu-Zn-based ferrite, Mg-Mn-Sr-based ferrite, Ni-Zn-based ferrite, Ba-Zn-based ferrite, Ba-Mg-based ferrite, Ba-Ni-based ferrite, Ba-Co-based ferrite, Ba-Ni-Co-based ferrite, Y-based ferrite, ferric oxide powder, and triiron tetraoxide; pure iron powder; iron alloy-based metal powder, such as Fe-Si-based alloy powder, Fe-Si-Al-based alloy powder, Fe-Cr-based alloy powder, Fe-Cr-Si-based alloy powder, Fe-Ni-Cr-based alloy powder, Fe-Cr-Al-based alloy powder, Fe-Ni-based alloy powder, Fe-Ni-Mo-based alloy powder, Fe-Ni-Mo-Cu-based alloy powder, Fe-Co-based alloy powder, and Fe-Ni-Co-based alloy powder; and amorphous alloys, such as a Co-group amorphous alloy.

In particular, the magnetic powder (A) is preferably at least one selected from iron oxide powder and iron alloy-based metal powder. The iron oxide powder preferably includes ferrite containing at least one selected from Ni, Cu, Mn, and Zn, and is more preferably at least one selected from Fe-Mn-based ferrite and Fe-Mn-Zn-based ferrite. The iron alloy-based metal powder preferably includes iron alloy-based metal powder containing at least one selected from Si, Cr, Al, Ni, and Co.

Commercially available magnetic powder may be used as the magnetic powder (A), and two or more kinds of the magnetic powder may be used in combination. Specific examples of the commercially available magnetic powder to be used include M-series, such as M05S, manufactured by Powdertech Co., Ltd.; MZ05, manufactured by Powdertech Co., Ltd.; PST-S, manufactured by Sanyo Special Steel Co., Ltd; AW2-08, AW2-08PF20F, AW2-08PF10F, AW2-08PF3F, Fe-3.5Si-4.5CrPF20F, Fe-50NiPF20F, and Fe-80Ni-4MoPF20F, manufactured by EPSON ATMIX Corporation; LD-M, LD-MH, KNI-106, KNI-106GSM, KNI-106GS, KNI-109, KNI-109GSM, and KNI-109GS, manufactured by JFE Chemical Corporation; KNS-415, BSF-547, BSF-029, BSN-125, BSN-714, BSN-828, S-1281, S-1641, S-1651, S-1470, S-1511, and S-2430, manufactured by TODA KOGYO CORP.; JR09P2, manufactured by Japan Metals & Chemicals Co., Ltd; NanoTek, manufactured by CIK NanoTek Corporation; JEMK-S and JEMK-H, manufactured by KINSEI MATEC CO., LTD; and Yttrium iron oxide, manufactured by ALDRICH.

The magnetic powder (A) preferably has a spherical shape. A value (an aspect ratio) obtained by dividing the length of the major axis of the magnetic powder by the length of the minor axis of the magnetic powder is preferably 2 or less, more preferably 1.5 or less, and still more preferably 1.2 or less. Generally, when the magnetic powder has not a spherical shape but a flat shape, relative magnetic permeability can be more easily enhanced. However, the magnetic powder having a spherical shape is particularly preferably used because, usually, magnetic loss can be reduced and a magnetic paste having a desirable viscosity can be achieved.

From the viewpoint of enhancing relative magnetic permeability, the average particle diameter of the magnetic powder (A) is preferably 0.01 µm or larger, more preferably 0.5 µm or larger, and still more preferably 1 µm or larger. In addition, the average particle diameter of the magnetic powder (A) is preferably 10 µm or smaller, more preferably 9 µm or smaller, and still more preferably 8 µm or smaller.

The average particle diameter of the magnetic powder (A) can be measured by laser diffraction scattering based on the Mie scattering theory. Specifically, the average particle diameter can be measured in such a manner that the particle size distribution of the magnetic powder is created on the basis of volume by using a laser diffraction scattering type particle size distribution measurement device, and a median diameter in the particle size distribution is taken as the average particle diameter. As a measurement sample, what is obtained by dispersing the magnetic powder in water by supersonic waves can be preferably used. As the laser diffraction scattering type particle size distribution measurement device, for example, LA-500, manufactured by HORIBA, Ltd. or SALD-2200, manufactured by SHIMADZU CORPORATION can be used.

From the viewpoint of enhancing relative magnetic permeability, the specific surface area of the magnetic powder (A) is preferably 0.05 m²/g or larger, more preferably 0.1 m²/g or larger, and still more preferably 0.3 m²/g or larger. In addition, the specific surface area of the magnetic powder (A) is preferably 10 m²/g or smaller, more preferably 8 m²/g or smaller, and still more preferably 5 m²/g or smaller. The specific surface area of the magnetic powder (A) can be measured by the BET method.

From the viewpoints of adjusting the viscosity of the magnetic paste and furthermore enhancing the moisture resistance and dispersibility thereof, the magnetic powder (A) may be subjected to treatment with a surface treatment agent. Examples of the surface treatment agent include a vinyl-silane-based coupling agent, a (meth)acrylic coupling agent, a fluorine-containing silane-based coupling agent, an amino-silane-based coupling agent, an epoxy-silane-based coupling agent, a mercapto-silane-based coupling agent, a silane-based coupling agent, alkoxy silane, an organosilazane compound, and a titanate-based coupling agent. The surface treatment agent may be used alone or two or more kinds thereof may be used in arbitrary combination.

Examples of a commercially available surface treatment agent include KBM1003 (vinyltriethoxysilane), manufactured by Shin-Etsu Chemical Co., Ltd; KBM503 (3-methacryloxypropyltriethoxysilane), manufactured by Shin-Etsu Chemical Co., Ltd; KBM403 (3-glycidoxypropyltrimethoxysilane), manufactured by Shin-Etsu Chemical Co., Ltd; KBM803 (3-mercaptopropyltrimethoxysilane), manufactured by Shin-Etsu Chemical Co., Ltd; KBE903 (3-aminopropyltriethoxysilane), manufactured by Shin-Etsu Chemical Co., Ltd; KBM573 (N-phenyl-3-aminopropyltrimethoxysilane), manufactured by Shin-Etsu Chemical Co., Ltd; SZ-31 (hexamethyldisilazane), manufactured by Shin-Etsu Chemical Co., Ltd; KBM103 (phenyltrimethoxysilane), manufactured by Shin-Etsu Chemical Co., Ltd; KBM-4803 (a long-chain epoxy type silane coupling agent), manufactured by Shin-Etsu Chemical Co., Ltd; and KBM-7103 (3,3,3-trifluoropropyltrimethoxysilane), manufactured by Shin-Etsu Chemical Co., Ltd.

From the viewpoint of enhancing the dispersibility of the magnetic powder (A), the degree of surface treatment with the surface treatment agent is preferably within a predetermined range. Specifically, 100 parts by mass of the magnetic powder (A) is surface-treated with preferably 0.01 to 5 parts by mass, preferably 0.05 to 3 parts by mass, and preferably 0.1 to 2 parts by mass of the surface treatment agent.

From the viewpoints of enhancing relative magnetic permeability and reducing loss, the content (% by volume) of the magnetic powder (A) is preferably 40% by volume or higher, more preferably 50% by volume or higher, and still more preferably 60% by volume or higher, with respect to 100% by volume of non-volatile components in the magnetic paste. In addition, the content of the magnetic powder (A) is preferably 85% by volume or lower, more preferably 80% by volume or lower, and still more preferably 70% by volume or lower.

From the viewpoints of enhancing relative magnetic permeability and reducing a loss factor, the content (% by mass) of the magnetic powder (A) is preferably 60% by mass or higher, more preferably 70% by mass or higher, and still more preferably 75% by mass or higher, with respect to 100% by mass of non-volatile components in the magnetic paste. In addition, the content of the magnetic powder (A) is preferably 98% by mass or lower, more preferably 95% by mass or lower, and still more preferably 90% by mass or lower.

Note that, in the present invention, the content of each of the components in the magnetic paste represents the amount of the component when the amount of non-volatile components in the magnetic paste is taken as 100% by mass, unless otherwise specified.

### (B) Epoxy resin

The magnetic paste contains the epoxy resin (B). Note that the component (B) is not a component equivalent to the reactive diluent (C). The component (B) may be used alone, or two or more kinds thereof may be used in combination.

Examples of the epoxy resin (B) include a bisphenol A epoxy resin; a bisphenol F epoxy resin; a bisphenol S epoxy resin; a bisphenol AF epoxy resin; a dicyclopentadiene epoxy resin; a trisphenol epoxy resin; a phenol novolac epoxy resin; a tert-butyl-catechol epoxy resin; epoxy resins having a condensed ring structure, such as a naphthol novolac epoxy resin, a naphthalene epoxy resin, a naphthol epoxy resin, and an anthracene epoxy resin; a glycidyl amine epoxy resin; a glycidyl ester epoxy resin; a cresol novolac epoxy resin; a biphenyl epoxy resin; a linear aliphatic epoxy resin; an epoxy resin having a butadiene structure; an alicyclic epoxy resin; a heterocyclic epoxy resin; a spiro ring-containing epoxy resin; a cyclohexane dimethanol epoxy resin; a trimethylol epoxy resin; a tetraphenyl ethane epoxy resin, and a resin in which core shell rubber particles are monodispersed in an epoxy resin. The epoxy resin (B) may be used alone, or two or more kinds thereof may be used in combination. The epoxy resin (B) is preferably at least one selected from a resin in which core shell rubber particles are monodispersed in an epoxy resin, a bisphenol A epoxy resin, and a bisphenol F epoxy resin.

The epoxy resin (B) preferably includes an epoxy resin having two or more epoxy groups in one molecule. The epoxy resin (B) preferably has an aromatic structure, and, in the case where the epoxy resin (B) includes two or more kinds of epoxy resins, at least one of the epoxy resins more preferably has an aromatic structure. The aromatic structure is a chemical structure generally defined as aromatic series, and includes polycyclic aromatic series and heteroaromatic rings. The ratio of an epoxy resin having two or more epoxy groups in one molecule is preferably 50% by mass or higher, more preferably 60% by mass or higher, and still more preferably 70% by mass or higher with respect to 100% by mass of non-volatile components of epoxy resins.

Epoxy resin includes an epoxy resin that remains liquid at a temperature of 25°C (hereinafter, sometimes referred to as "the liquid epoxy resin") and an epoxy resin that remains solid at a temperature of 25°C (hereinafter, sometimes referred to as "the solid epoxy resin"). The magnetic paste may contain only the liquid epoxy resin or may contain only the solid epoxy resin, as the epoxy resin (B), but, from the viewpoints of lowering the viscosity of the magnetic paste and more easily filling the through hole with the magnetic paste, the magnetic paste preferably contains only the liquid epoxy resin.

The liquid epoxy resin is preferably a bisphenol A epoxy resin, a bisphenol F epoxy resin, a bisphenol AF epoxy resin, a naphthalene epoxy resin, a glycidyl ester epoxy resin, a glycidyl amine epoxy resin, a phenol novolac epoxy resin, a cycloaliphatic epoxy resin having an ester skeleton, a cyclohexanedimethanol epoxy resin, or an epoxy resin having a butadiene structure, and more preferably a glycidyl amine epoxy resin, a bisphenol A epoxy resin, a bisphenol F epoxy resin, a bisphenol AF epoxy resin, or a naphthalene epoxy resin. Specific examples of the liquid epoxy resin include HP4032, HP4032D, and HP4032SS (naphthalene epoxy resins), manufactured by DIC Corporation; 828US and jER828EL (bisphenol A epoxy resins), jER807 (a bisphenol F epoxy resin), and jER152 (a phenol novolac epoxy resin), manufactured by Mitsubishi Chemical Corporation; 630 and 630LSD (glycidyl amine epoxy resins), manufactured by Mitsubishi Chemical Corporation; ZX1059 (a mixed product of a bisphenol A epoxy resin and a bisphenol F epoxy resin), manufactured by NIPPON STEEL Chemical & Material Co., Ltd.; EX-721 (a glycidyl ester epoxy resin), manufactured by Nagase ChemteX Corporation; PB-3600 (an epoxy resin having a butadiene structure); and MX-153 (a bisphenol A epoxy resin containing an organic filler having a core shell structure), manufactured by KANEKA CORPORATION. These liquid epoxy resins may be used alone, or two or more of them may be used in combination.

The solid epoxy resin is preferably a naphthalene tetrafunctional epoxy resin, a cresol novolac epoxy resin, a dicyclopentadiene epoxy resin, a trisphenol epoxy resin, a naphthol epoxy resin, a biphenyl epoxy resin, a naphthylene ether epoxy resin, an anthracene epoxy resin, a bisphenol A epoxy resin, or a tetraphenylethane epoxy resin, and more preferably a naphthalene tetrafunctional epoxy resin, a naphthol epoxy resin, or a biphenyl epoxy resin. Specific examples of the solid epoxy resin include HP4032H (a naphthalene epoxy resin), HP-4700 and HP-4710 (naphthalene tetrafunctional epoxy resins), N-690 (a cresol novolac epoxy resin), N-695 (a cresol novolac epoxy resin), HP-7200, HP-7200HH, and HP-7200H (dicyclopentadiene epoxy resins), EXA-7311, EXA-7311-G3, EXA-7311-G4, EXA-7311-G4S, and HP6000 (naphtylene ether epoxy resins), manufactured by DIC Corporation; EPPN-502H (a trisphenol epoxy resin), NC7000L (a naphthol novolac epoxy resin), NC3000H, NC3000, NC3000L, and NC3100 (biphenyl epoxy resins), manufactured by Nippon Kayaku Co., Ltd.; ESN475V (a naphthalene epoxy resin) and ESN485 (a naphthol novolac epoxy resin), manufactured by NIPPON STEEL Chemical & Material Co., Ltd.; YX4000H and YL6121 (biphenyl epoxy resins), YX4000HK (a bixylenol epoxy resin), and YX8800 (an anthracene epoxy resin), manufactured by Mitsubishi Chemical Corporation; PG-100 and CG-500, manufactured by Osaka Gas Chemicals Co., Ltd., and YL7760, manufactured by Mitsubishi Chemical Corporation (bisphenol AF epoxy resins), and YL7800 (a fluorene epoxy resin), jER1010 (a solid bisphenol A epoxy resin), and jER1031S (a tetraphenylethane epoxy resin), manufactured by Mitsubishi Chemical Corporation. These solid epoxy resins may be used alone or two or more kinds thereof may be used in combination.

When a liquid epoxy resin and a solid epoxy resin are used in combination as the epoxy resin (B), the mass ratio of these epoxy resins (liquid epoxy resin: solid epoxy resin) preferably falls within a range of 1:0.01 to 1:2. When the mass ratio of the liquid epoxy resin to the solid epoxy resin falls within the above-mentioned range, for example, the effect of achieving a cured product having sufficient breaking strength can be produced. From the viewpoint of the above-mentioned effect, the mass ratio of the liquid epoxy resin to the solid epoxy resin (liquid epoxy resin: solid epoxy resin) falls within preferably a range of 1:0.02 to 1:1, more preferably a range of 1:0.03 to 1:0.5, and still more preferably a range of 1:0.05 to 1:0.3.

From the viewpoint of achieving a magnetic layer excellent in mechanical strength, the content of the epoxy resin (B) is preferably 1% by mass or higher, more preferably 5% by mass or higher, and still more preferably 10% by mass or higher, and preferably 30% by mass or lower, more preferably 20% by mass or lower, and still more preferably 15% by mass or lower, with respect to 100% by mass of the non-volatile components in the magnetic paste.

From the viewpoint of achieving a magnetic layer excellent in mechanical strength and insulation reliability, the content (% by volume) of the epoxy resin (B) is preferably 1% by volume or higher, more preferably 3% by volume or higher, and still more preferably 5% by volume or higher, and preferably 30% by volume or lower, more preferably 27% by volume or lower, and still more preferably 25% by volume or lower, with respect to 100% by volume of the non-volatile components in the magnetic paste.

The epoxy equivalent of the epoxy resin (B) is preferably 50 g/eq. to 5000 g/eq., more preferably 50 g/eq. to 3000 g/eq., still more preferably 60 g/eq. to 2000 g/eq., and still more preferably 70 g/eq. to 1000 g/eq. When the epoxy equivalent is within the above-mentioned range, whereby a magnetic layer having a sufficient crosslinking density of a cured product can be offered. Note that the epoxy equivalent can be measured in accordance with JIS K7236, and is the mass of a resin containing one equivalent of epoxy group.

The viscosity of the epoxy resin (B) is preferably 0.5 Pa·s or higher, and preferably 1000 Pa·s or lower, more preferably 500 Pa·s or lower, and still more preferably 100 Pa·s or lower. Here, the viscosity of the epoxy resin is measured at 25°C ± 2°C by the use of an E-type viscometer.

The weight-average molecular weight of the epoxy resin (B) is preferably 100 or more, more preferably 250 or more, and still more preferably 400 or more, and preferably 5000 or less, more preferably 3000 or less, and still more preferably 1500 or less. Here, the weight-average molecular weight of the epoxy resin is a weight-average molecular weight in terms of polystyrene, measured by gel permeation chromatography (GPC).

### (C) Reactive diluent

The magnetic paste contains the reactive diluent (C). In the present invention, a tri- or higher functional reactive diluent is contained as the component (C). Generally, a higher content of the magnetic powder (A) in the magnetic paste causes problems of the present invention, that is, a more considerable decrease in desmear resistance and a more considerable decrease in adhesion between a magnetic layer and a conductive layer. However, the magnetic paste of the present invention contains a tri- or higher functional reactive diluent, and therefore, even when the content of the magnetic powder (A) is high, a cured product having enhanced desmear resistance and enhanced adhesion between the magnetic layer and the conductive layer can be obtained. The component (C) may be used alone, or two or more kinds thereof may be used in combination.

The reactive diluent (C) contains a tri- or higher functional reactive diluent. The tri- or higher functional reactive diluent is a reactive diluent having three or more reactive groups. The tri- or higher functional reactive diluent is preferably a tetra- or higher functional reactive diluent, and more preferably a penta- or higher functional reactive diluent, and is preferably a deca- or lower functional reactive diluent, more preferably an octa- or lower functional reactive diluent, and still more preferably a hexa- or lower functional reactive diluent.

Examples of the reactive group include an epoxy group, an acrylic group, a methacryl group, and an oxetane group. From the viewpoint of lowering the viscosity of the magnetic paste, the reactive group is particularly preferably an epoxy group.

Besides the tri- or higher functional reactive diluent, the reactive diluent (C) may contain a reactive diluent having two or less of the above-mentioned reactive groups, namely, a di- or lower functional reactive diluent.

From the viewpoint of remarkably achieving the effects of the present invention, the content of the tri- or higher functional reactive diluent is preferably 20% by mass or higher, more preferably 25% by mass or higher, still more preferably 30% by mass or higher, and still more preferably 35% by mass or higher, and preferably 100% by mass or lower, more preferably 95% by mass or lower, and still more preferably 90% by mass or lower, with respect to 100% by mass of the entirety of the component (C).

A commercially available tri- or higher functional reactive diluent can be used. Specific examples of the commercially available tri- or higher functional reactive diluent to be used include EX-321L (aliphatic triglycidyl ether), manufactured by Nagase ChemteX Corporation; PETG (aliphatic tetraglycidyl ether), manufactured by Showa Denko K.K.; and ED-505 (aliphatic triglycidyl ether), manufactured by ADEKA Corporation. These may be used alone, or two or more kinds thereof may be used in combination.

From the viewpoint of remarkably achieving the effects of the present invention, the content of the di- or lower functional reactive diluent is preferably 0% by mass or higher, more preferably 5% by mass or higher, and still more preferably 10% by mass or higher, and preferably 80% by mass or lower, more preferably 75% by mass or lower, still more preferably 70% by mass or lower, and still more preferably 65% by mass or lower, with respect to 100% by mass of the entirety of the component (C).

A commercially available di- or lower functional reactive diluent can be used. Specific examples of the commercially available di- or lower functional reactive diluent to be used include EX-201 (cyclic aliphatic glycidyl ether), manufactured by NIPPON STEEL Chemical & Material Co., Ltd.; EX-830 and EX-821 (ethylene glycol epoxy resins); EX-212 (a hexanediol epoxy resin); ZX1658 and ZX1658GS (liquid 1,4-glycidyl cyclohexane); EP-3980S (a glycidyl amine epoxy resin), EP-4088S and EP-4088L (dicyclopentadiene epoxy resins), and ED-509S (tertbutylphenyl glycidyl ether), manufactured by ADEKA Corporation; and X-22-163 (a siloxane epoxy resin), manufactured by Shin-Etsu Chemical Co., Ltd. These may be used alone, or two or more of them may be used in combination.

The viscosity of the reactive diluent (C) is preferably 0.001 Pa·s or higher, more preferably 0.005 Pa·s or higher, and still more preferably 0.01 Pa·s or higher. The upper limit of the viscosity is lower than 0.5 Pa·s. The viscosity of the reactive diluent can be measured by the same method as that for the viscosity of the epoxy resin (B).

In the case where the reactive diluent (C) has a glycidyl group or an epoxy group, the epoxy equivalent of the reactive diluent (C) is preferably 50 g/eq. to 5000 g/eq., more preferably 50 g/eq. to 3000 g/eq., still more preferably 60 g/eq. to 2000 g/eq., and still more preferably 70 g/eq. to 1000 g/eq. When the epoxy equivalent is within the above-mentioned range, a magnetic layer having a sufficient crosslinking density of a cured product can be offered.

From the viewpoint of remarkably obtaining the effects of the present invention, the content of the reactive diluent (C) is preferably 0.5% by mass or higher, more preferably 1% by mass or higher, still more preferably 3% by mass or higher, with respect to 100% by mass of non-volatile components in the magnetic paste. The upper limit of the content is preferably 10% by mass or lower, more preferably 7% by mass or lower, and still more preferably 5% by mass or lower.

From the viewpoint of remarkably achieving the effects of the present invention, the content of the tri- or higher functional reactive diluent is preferably 0.5% by mass or higher, more preferably 1% by mass or higher, and still more preferably 2% by mass or higher, and preferably 10% by mass or lower, more preferably 7% by mass or lower, and still more preferably 5% by mass or lower, with respect to 100% by mass of the non-volatile components in the magnetic paste.

From the viewpoint of remarkably achieving the effects of the present invention, the content of the di- or lower functional reactive diluent is preferably 0% by mass or higher, more preferably 0.1% by mass or higher, and still more preferably 0.3% by mass or higher, and preferably 3% by mass or lower, more preferably 1.5% by mass or lower, and still more preferably 1% by mass or lower, with respect to 100% by mass of the non-volatile components in the magnetic paste.

When the content (% by mass) of the tri- or higher functional reactive diluent is taken as C3 with respect to 100% by mass of the non-volatile components in the magnetic paste and the content (% by mass) of the di- or lower functional reactive diluent is taken as C2 with respect to 100% by mass of the non-volatile components in the magnetic paste, C2/(C2+C3) is preferably 0 or more, more preferably 0.1 or more, and still more preferably 0.2 or more, and preferably 5 or less, more preferably 1 or less, and still more preferably 0.7 or less. The content of each of the tri- or higher functional reactive diluent and the di- or lower functional reactive diluent is adjusted so as to achieve C2/(C2+C3) within the above-mentioned range, whereby the desired effects of the present invention can be more remarkably achieved.

When the content (% by mass) of the reactive diluent (C) is taken as C1 with respect to 100% by mass of the non-volatile components in the magnetic paste and the content (% by mass) of the epoxy resin (B) is taken as B1 with respect to 100% by mass of the non-volatile components in the magnetic paste, B1/C1 is preferably 0.1 or more, more preferably 0.5 or more, still more preferably 1 or more, and still more preferably 3 or more, and preferably 10 or less, more preferably 8 or less, and still more preferably 5 or less. The content of each of the component (B) and the component (C) is adjusted so as to achieve B1/C1 within the above-mentioned range, whereby the desired effects of the present invention can be more remarkably achieved.

Furthermore, B1/C3 is preferably 1 or more, more preferably 2 or more, and still more preferably 3 or more, and preferably 20 or less, more preferably 10 or less, and still more preferably 8 or less. The content of each of the component (B) and the component (C) is adjusted so as to achieve B1/C3 within the above-mentioned range, whereby the desired effects of the present invention can be more remarkably achieved.

### (D) Curing agent

The magnetic paste contains the curing agent (D). The curing agent (D) includes an epoxy resin curing agent having the function of curing the epoxy resin (B) and a curing accelerator having the function of accelerating the curing rate of the epoxy resin (B). The magnetic paste preferably contains either the epoxy resin curing agent or the curing accelerator, as the curing agent (D), and more preferably contains the curing accelerator.

### Epoxy resin curing agent

Examples of the epoxy resin curing agent include an acid anhydride-based epoxy resin curing agent, a phenol-based epoxy resin curing agent, a naphthol-based epoxy resin curing agent, an active ester-based epoxy resin curing agent, a benzoxazine-based epoxy resin curing agent, a cyanate ester-based epoxy resin curing agent, and an amine-based epoxy resin curing agent. From the viewpoint of lowering the viscosity of the magnetic paste, the epoxy resin curing agent is preferably an acid anhydride-based epoxy resin curing agent. The epoxy resin curing agent may be used alone, or two or more kinds thereof may be used in combination.

Examples of the acid anhydride-based epoxy resin curing agent include an epoxy resin curing agent having one or more acid anhydride groups in one molecule. Specific examples of the acid anhydride-based epoxy resin curing agent include phthalic anhydride, tetrahydrophthalic anhydride, hexahydrophthalic anhydride, methyltetrahydrophthalic anhydride, methylhexahydrophthalic anhydride, methyl nadic anhydride, hydrogenated methyl nadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and an acid anhydride polymer such as a styrene-maleic-acid resin obtained by copolymerization of styrene and maleic acid.

Examples of a commercially available acid anhydride-based epoxy resin curing agent include HNA-100 and MH-700, manufactured by New Japan Chemical Co., Ltd.

From the viewpoints of heat-resistance and water-resistance, the phenol-based epoxy resin curing agent and the naphthol-based epoxy resin curing agent are preferably a phenol-based epoxy resin curing agent having a novolac structure and a naphthol-based epoxy resin curing agent having a novolac structure, respectively. The phenol-based epoxy resin curing agent is preferably a nitrogen-containing phenol-based epoxy resin curing agent, more preferably a triazine skeleton-containing phenol-based epoxy resin curing agent, and still more preferably a triazine skeleton-containing phenol novolac epoxy resin curing agent.

Specific examples of the phenol-based epoxy resin curing agent and the naphthol-based epoxy resin curing agent include MEH-7700, MEH-7810, and MEH-8000, manufactured by Meiwa Plastic Industries, Ltd.; NHN, CBN, and GPH, manufactured by Nippon Kayaku Co., Ltd.; SN170, SN180, SN190, SN475, SN485, SN495V, SN375, and SN395, manufactured by NIPPON STEEL Chemical & Material Co., Ltd.; TD-2090, LA-7052, LA-7054, LA-1356, LA-3018-50P, EXB-9500, HPC-9500, KA-1160, KA-1163, and KA-1165, manufactured by DIC Corporation; and GDP-6115L and GDP-6115H, manufactured by Gun Ei Chemical Industry Co., Ltd.

The active ester-based epoxy resin curing agent is, but not particularly limited to, generally preferably a compound having two or more highly reactive ester groups in one molecule, such as phenol esters, thiophenol esters, N-hydroxyamine esters, and esters of heterocyclic hydroxy compounds. The active ester-based epoxy resin curing agent is preferably obtained by a condensation reaction of a carboxylic acid compound and/or a thiocarboxylic acid compound with a hydroxy compound and/or a thiol compound. In particular, from the viewpoint of enhancing heat resistance, the active ester-based epoxy resin curing agent is preferably an active ester-based epoxy resin curing agent obtained from a carboxylic acid compound and a hydroxy compound, and more preferably an active ester-based epoxy resin curing agent obtained from a carboxylic acid compound and a phenol compound and/or a naphthol compound. Examples of the carboxylic acid compound include benzoic acid, acetic acid, succinic acid, maleic acid, itaconic acid, phthalic acid, isophthalic acid, terephthalic acid, and pyromellitic acid. Examples of the phenol compound and the naphthol compound include hydroquinone, resorcinol, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene diphenol compound, and phenol novolac. Here, the term "dicyclopentadiene diphenol compound" is a diphenol compound obtained by condensation of two molecules of phenol and one molecule of dicyclopentadiene.

Specifically, an active ester-based epoxy resin curing agent having a dicyclopentadiene diphenol structure, an active ester-based epoxy resin curing agent having a naphthalene structure, an active ester-based epoxy resin curing agent containing acetylated phenol novolac, and an active ester-based epoxy resin curing agent containing benzoylated phenol novolac are preferably used. The term "dicyclopentadiene diphenol structure" is a divalent structure composed of phenylene-dicyclopentylene-phenylene.

Examples of a commercially available active ester-based epoxy resin curing agent include EXB9451, EXB9460, EXB9460S, HPC-8000-65T, HPC-8000H-65TM, and EXB-8000L-65TM, manufactured by DIC Corporation, as the active ester-based epoxy resin curing agent having a dicyclopentadiene diphenol structure; EXB9416-70BK, manufactured by DIC Corporation, as the active ester compound having a naphthalene structure; DC808, manufactured by Mitsubishi Chemical Corporation, as the active ester-based epoxy resin curing agent containing acetylated phenol novolac; YLH1026, YLH1030, and YLH1048, manufactured by Mitsubishi Chemical Corporation, as the active ester-based epoxy resin curing agent containing benzoylated phenol novolac; and DC808, manufactured by Mitsubishi Chemical Corporation, as the active ester-based epoxy resin curing agent containing acetylated phenol novolac.

Specific examples of the benzoxazine-based epoxy resin curing agent include HFB2006M, manufactured by Showa Highpolymer Co., Ltd., and P-d and F-a, manufactured by SHIKOKU CHEMICALS CORPORATION.

Examples of the cyanate ester-based epoxy resin curing agent include difunctional cyanate resins, such as bisphenol A dicyanate, polyphenol cyanate, oligo(3-methylene-1,5-phenylenecyanate), 4,4'-methylenebis(2,6-dimethylphenyl cyanate), 4,4'-ethylidenediphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; polyfunctional cyanate resins derived from, for example, phenol novolac and cresol novolac; and prepolymers in which these cyanate esters are partially triazinized. Specific examples of the cyanate ester-based epoxy resin curing agent include PT30 and PT60 (both are phenol novolac polyfunctional cyanate ester resins) and BA230 and BA230S75 (prepolymers in which bisphenol A dicyanate is partially or entirely triazinized to form a trimer), manufactured by Lonza Japan Ltd.

Examples of the amine-based epoxy resin curing agent include an epoxy resin curing agent containing an amine having one or more active hydrogen atoms in one molecule. Specific examples of the amine-based epoxy resin curing agent include diethylenetriamine, triethylenetetramine, diaminodiphenyl sulfone, and dicyandiamide.

Examples of a commercially available amine-based epoxy resin curing agent include DICY7, manufactured by Mitsubishi Chemical Corporation.

The amount ratio of an epoxy resin to an epoxy resin curing agent is the ratio of [the total number of epoxy groups in the epoxy resin] : [the total number of reactive groups in the epoxy resin curing agent], and is preferably in a range of 1:0.2 to 1:2, more preferably in a range of 1:0.3 to 1:1.5, and still more preferably in a range of 1:0.4 to 1:1. Here, the reaction groups of the epoxy resin curing agent are, for example, an active hydroxyl group and an active ester group, and are different depending on the kind of the epoxy resin curing agent. The total number of epoxy groups in the epoxy resin is a value obtained by dividing the mass of non-volatile components in the epoxy resins by respective epoxy equivalents and summing the resulting values for all the epoxy resins. The total number of reactive groups in the epoxy resin curing agent is a value obtained by dividing the mass of non-volatile components in the epoxy resin curing agents by respective reactive group equivalents and summing the resulting values for all the epoxy resin curing agents. When the amount ratio of the epoxy resin to the epoxy resin curing agent is in the above-mentioned range, a resulting cured product has higher heat-resistance.

From the viewpoint of remarkably achieving the desired effects of the present invention, the content of the epoxy resin curing agent is preferably 0.1% by mass or higher, more preferably 0.2% by mass or higher, and still more preferably 0.3% by mass or higher, with respect to 100% by mass of the non-volatile components in the magnetic paste. The upper limit of the content is preferably 5% by mass or lower, more preferably 3% by mass or lower, and still more preferably 1% by mass or lower.

### Curing accelerator

Examples of the curing accelerator include an amine-based curing accelerator, an imidazole-based curing accelerator, a phosphorus-based curing accelerator, a guanidine-based curing accelerator, and a metal-based curing accelerator. The curing accelerator may be used alone or two or more kinds thereof may be used in combination.

Examples of the amine-based curing accelerator include trialkylamines such as triethylamine and tributylamine, 4-dimethylaminopyridine, benzyldimethylamine, 2,4,6-tris(dimethylaminomethyl)phenol, and 1,8-diazabicyclo(5,4,0)-undecene. The amine-based curing accelerator is preferably 4-dimethylaminopyridine or 1,8-diazabicyclo(5,4,0)-undecene.

As the amine-based curing accelerator, a commercially available amine-based curing accelerator may be used, and examples thereof include MY-25 manufactured by Ajinomoto Fine-Techno Co., Inc.

Examples of the imidazole-based curing accelerator include imidazole compounds, such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyls-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline; and an adduct of an imidazole compound and an epoxy resin. The imidazole-based curing accelerator is preferably 2-ethyl-4-methylimidazole or 1-benzyl-2-phenylimidazole.

As the imidazole-based curing accelerator, a commercially available imidazole-based curing accelerator may be used, and examples thereof include 2MZA-PW and 2PHZ-PW, manufactured by SHIKOKU CHEMICALS CORPORATION, and P200-H50, manufactured by Mitsubishi Chemical Corporation.

Examples of the phosphorus-based curing accelerator include triphenylphosphine, a phosphonium borate compound, tetraphenylphosphonium tetraphenylborate, n-butylphosphonium tetraphenylborate, tetrabutylphosphonium decanoate, (4-methylphenyl)triphenylphosphonium thiocyanate, tetraphenylphosphonium thiocyanate, and butyltriphenylphosphonium thiocyanate. The phosphorus-based curing accelerator is preferably triphenylphosphine or tetrabutylphosphonium decanoate.

Examples of the guanidine-based curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide. The guanidine-based curing accelerator is preferably dicyandiamide or 1,5,7-triazabicyclo[4.4.0]dec-5-ene.

Examples of the metal-based curing accelerator include organic metal complexes and organic metal salts of metals such as cobalt, copper, zinc, iron, nickel, manganese, and tin. Specific examples of the organic metal complex include organic cobalt complexes, such as cobalt (II) acetylacetonate and cobalt (III) acetylacetonate, an organic copper complex such as copper (II) acetylacetonate, an organic zinc complex such as zinc (II) acetylacetonate, an organic iron complex such as iron (III) acetylacetonate, an organic nickel complex such as nickel (II) acetylacetonate, and an organic manganese complex such as manganese (II) acetylacetonate. Examples of the organic metal salt include zinc octoate, tin octoate, zinc naphthenate, cobalt naphthenate, tin stearate, and zinc stearate.

From the viewpoint of achieving the desired effects of the present invention, the curing agent (D) is preferably a curing accelerator, more preferably at least one selected from an amine-based curing accelerator and an imidazole-based curing accelerator, and still more preferably an imidazole-based curing accelerator.

From the viewpoint of lowering the viscosity of the magnetic paste, the content of the curing accelerator is preferably 0.1% by mass or higher, more preferably 0.2% by mass or higher, and still more preferably 0.3% by mass or higher, with respect to 100% by mass of the non-volatile components in the magnetic paste. The upper limit of the content is preferably 5% by mass or lower, more preferably 3% by mass or lower, and still more preferably 1% by mass or lower.

From the viewpoint of remarkably achieving the desired effects of the present invention, the content of the curing agent (D) is preferably 0.1% by mass or higher, more preferably 0.2% by mass or higher, and still more preferably 0.3% by mass or higher, with respect to 100% by mass of the non-volatile components in the magnetic paste. The upper limit of the content is preferably 5% by mass or lower, more preferably 3% by mass or lower, and still more preferably 1% by mass or lower.

### (E) Dispersant

The magnetic paste may further contain a dispersant (E) as an optional component.

Examples of the dispersant (E) include phosphate-based dispersants, such as polyoxyethylene alkyl ether phosphate; anionic dispersants, such as sodium dodecylbenzene sulfonate, sodium lauryl sulfate, and an ammonium salt of polyoxyethylene alkylether sulfate; and nonionic dispersants, such as an organosiloxane-based dispersant, acetyleneglycol, polyoxyethylene alkyl ether, polyoxyethylene alkyl ester, polyoxyethylene sorbitan fatty acid ester, polyoxyethylene alkyl phenyl ether, polyoxyethylene alkylamine, and polyoxyethylene alkyl amide. In particular, the dispersant (E) is preferably an anionic dispersant. The dispersant may be used alone, or two or more kinds thereof may be used in combination.

A commercially available phosphate-based dispersant can be used. Examples of the commercially available phosphate-based dispersant include phosphanol series RS-410, RS-610, and RS-710, manufactured by TOHO Chemical Industry Co., Ltd.

Examples of a commercially available organosiloxane-based dispersant include BYK347 and BYK348, manufactured by BYK-Chemie GmbH.

Examples of a commercially available polyoxyalkylene-based dispersant include MALIALIM series AKM-0531, AFB-1521, SC-0505K, SC-1015F, and SC-0708A, and HKM-50A, manufactured by NOF CORPORATION. The polyoxyalkylene-based dispersant is a general term for polyoxyethylene alkyl ether, polyoxyethylene alkyl ester, polyoxyethylene sorbitan fatty acid ester, polyoxyethylene alkyl phenyl ether, polyoxyethylene alkylamine, and polyoxyethylene alkyl amide.

Examples of commercially available acetyleneglycol include SURFYNOL series 82, 104, 440, 465, and 485, and Olefin Y, manufactured by Air Products and Chemicals Inc.

From the viewpoint of remarkably achieving the effects of the present invention, the content of the dispersant (E) is preferably 0.1% by mass or higher, more preferably 0.3% by mass or higher, and still more preferably 0.5% by mass or higher, with respect to 100% by mass of the non-volatile components in the magnetic paste. The upper limit of the content is preferably 5% by mass or lower, more preferably 3% by mass or lower, and still more preferably 1% by mass or lower.

### (F) Other additives

The magnetic paste may further contain other additives (F), if needed. Examples of the other additives include a thermoplastic resin; a curing retardant, such as triethyl borate, for the purpose of enhancing preservation stability; an inorganic filler (except an inorganic filler equivalent to the magnetic powder); a fire retardant; an organic filler; organometallic compounds, such as an organocopper compound, an organozinc compound; and an organocobalt compound, and resin additives, such as a thickener, a defoaming agent, a leveling agent, an adhesion imparting agent, and a colorant.

The content of the above-mentioned solvent in the magnetic paste is preferably less than 1.0% by mass, more preferably 0.8% by mass or lower, still more preferably 0.5% by mass or lower, and particularly preferably 0.1% by mass or lower, with respect to the total mass of the magnetic paste. The lower limit of the content is not particularly limited, but is 0.001% by mass or higher, or alternatively the magnetic paste does not contain the solvent. When the content of the organic solvent is kept within the above-mentioned range, the generation of a void can be substantially prevented and the handleability and workability of the magnetic paste can be increased.

The viscosity of the magnetic paste is usually 20 Pa·s or higher, preferably 25 Pa·s or higher, and more preferably 30 Pa·s or higher or 50 Pa·s or higher, and usually less than 200 Pa·s, preferably 180 Pa·s or lower, and more preferably 160 Pa·s or lower. The viscosity can be measured by the same method as that for measuring the viscosity of the epoxy resin (B).

### Method for producing magnetic paste

The magnetic paste can be produced, for example, by stirring blending components with a stirrer, such as a three-roll mill or a rotary mixer. The components (A) to (F) can be mixed in any order.

### Physical properties and other properties of magnetic paste

Even when a cured product of the magnetic paste is subjected to desmearing, no blister develops, and hence, the cured product of the magnetic paste has the property of being excellent in plating adhesion to a plating layer. Therefore, the cured product brings about a magnetic layer excellent in peel strength between the magnetic layer and the plating layer. The peel strength, which indicates plating adhesion, is preferably 0.1 kgf/cm or more, more preferably 0.15 kgf/cm or more, and still more preferably 0.2 kgf/cm or more. The upper limit of the peel strength is not particularly limited, but may be 1.0 kgf/cm or less, for example. The peel strength can be measured by a method described in the later-mentioned examples.

The cured product of the magnetic paste usually has the property of having a high relative magnetic permeability at a frequency of 100 MHz. Accordingly, the cured product brings about the magnetic layer having a high relative magnetic permeability. The relative magnetic permeability of this cured product at a frequency of 100 MHz is preferably 3 or more, more preferably 4 or more, and still more preferably 5 or more. The upper limit of the relative magnetic permeability is not particularly limited, but may be 20 or less, for example. The relative magnetic permeability can be measured by a method described in the later-mentioned examples.

The cured product of the magnetic paste usually has the property of having a smaller magnetic loss at a frequency of 100 MHz. Accordingly, the cured product brings about the magnetic layer having a smaller magnetic loss. The magnetic loss of this cured product at a frequency of 100 MHz is preferably 1 or less, more preferably 0.5 or less, and still more preferably 0.2 or less. The lower limit of the magnetic loss is not particularly limited, but may be 0.001 or more, for example. The magnetic loss can be measured by a method described in the later-mentioned examples.

The magnetic paste has the property of having a low viscosity. Therefore, the magnetic paste can be preferably used as a magnetic paste for filling a through hole.

### Circuit board and manufacturing method of same

A circuit board includes a substrate in which a through hole is filled with a cured product of the magnetic paste of the present invention. The magnetic paste of the present invention is used in the circuit board, and therefore, the circuit board is excellent in desmear resistance, and as a result, a magnetic layer having a desired shape can be obtained. Furthermore, since the magnetic paste of the present invention has a suitable viscosity, the magnetic paste is excellent for being filled into a through hole.

The circuit board can be manufactured, for example, using the above-described magnetic paste, by a method including the following steps (1) to (4) in this order.
(1) filling a through hole with the magnetic paste and thermally-curing the magnetic paste to obtain a cured product
(2) polishing a surface of the cured product
(3) desmearing (roughening) the polished surface of the cured product
(4) forming a conductive layer on the polished surface of the cured product

The step (1) may include the step of preparing the magnetic paste. The magnetic paste is as described above.

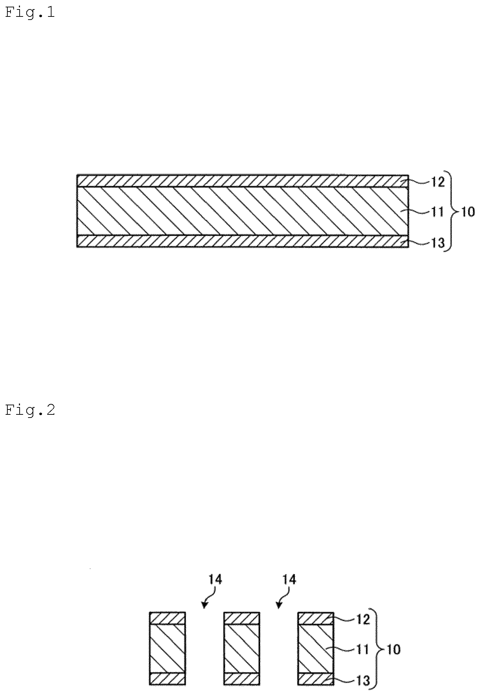

The step (1) may include the step of preparing a core substrate 10, as illustrated in an example in FIG. 1. A core substrate 10 to be explained here as an example includes a support substrate 11, and a first metal layer 12 and a second metal layer 13 that are provided on the respective surfaces of the support substrate 11 and formed of copper foil, for example. Examples of a material of the support substrate 11 include a glass epoxy substrate, a metal substrate, a polyester substrate, a polyimide substrate, a bismaleimide triazine (BT) resin substrate, and a thermosetting polyphenylene ether substrate.

As illustrated in an example in FIG. 2, the step (1) may include the step of forming a through hole 14 in the core substrate 10. The through hole 14 can be formed by, for example, drilling, laser irradiation, or plasma irradiation. Specifically, the through hole 14 can be formed in such a manner that a through hole is formed in the core substrate 10 by drilling, for example.

The formation of the through hole 14 can be performed using a commercially available drilling apparatus. Examples of the commercially available drilling apparatus include ND-1S211, manufactured by Hitachi Via Mechanics, Ltd.

After the formation of the through hole 14 in the core substrate 10, the step may include the step of roughening the core substrate 10 and forming a plating layer inside the through hole 14, on a surface of the first metal layer 12, and on a surface of the second metal layer 13.

As the above-described roughening, any of dry roughening and wet roughening may be performed. Examples of the dry roughening include plasma processing. Examples of the wet roughening include a method in which swelling treatment with a swelling solution, roughening treatment with an oxidant, and neutralization treatment with a neutralization solution are performed in this order.

The plating layer is formed by plating. A procedure for forming the plating layer by the plating is the same as that for forming a conductive layer at the step (4) described later.

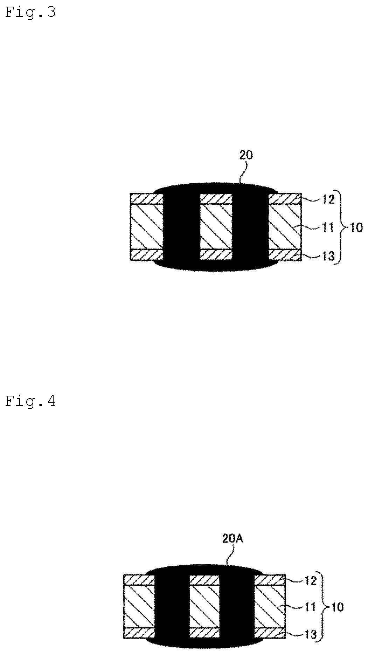

After the core substrate 10 having the through hole 14 formed therein is prepared, the through hole 14 is filled with the magnetic paste 20 as illustrated in an example in FIG. 3. The filling is usually performed by screen printing, but may be performed by another method, such as a method of filling with the magnetic paste 20 by means of a dispenser, a method of filling the through hole 14 with the magnetic paste 20 by means of a squeegee, a method of filling with the magnetic paste 20 by means of a cartridge, a method of filling with the magnetic paste 20 by mask printing, a roll coating method, or an inkjet method.

After the through hole 14 is filled with the magnetic paste 20, the magnetic paste 20 is thermally-cured to form a magnetic layer 20A in the through hole 14, as illustrated in an example in FIG. 4. Conditions for thermally-curing the magnetic paste 20 are different in accordance with a composition and a kind of the magnetic paste 20, but the curing temperature is preferably 120°C or higher, more preferably 130°C or higher, and still more preferably 150°C or higher, and preferably 240°C or lower, more preferably 220°C or lower, and still more preferably 200°C or lower. Time to cure the magnetic paste 20 is preferably 5 minutes or longer, more preferably 10 minutes or longer, and still more preferably 15 minutes or longer, and preferably 120 minutes or shorter, more preferably 100 minutes or shorter, and still more preferably 90 minutes or shorter.

The degree of cure of the magnetic layer 20A at the step (1) is preferably 80% or higher, more preferably 85% or higher, and still more preferably 90% or higher. The degree of cure can be measured, for example, using a differential scanning calorimeter.

Prior to the thermally-curing of the magnetic paste 20, the magnetic paste 20 may be subjected to preheating treatment to be heated at a temperature lower than the curing temperature. For example, prior to the thermally-curing of the magnetic paste 20, the magnetic paste 20 may be preheated, normally at a temperature of 50°C or higher and less than 120°C (preferably 60°C or higher and 110°C or lower, and more preferably 70°C or higher and 100°C or lower), normally for 5 minutes or longer (preferably for 5 minutes to 150 minutes, and more preferably for 15 minutes to 120 minutes).

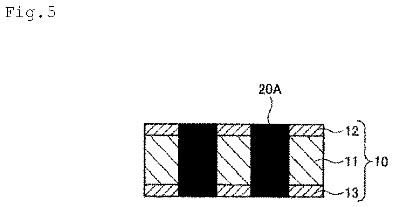

At the step (2), as illustrated in an example in FIG. 5, an excessive magnetic layer 20A protruding from or adhering to the core substrate 10 is removed by polishing to planarize the surface. As a method for the polishing, use can be made of a method capable of polishing the excessive magnetic layer 20A protruding from or adhering to the core substrate 10. Examples of the method for the polishing include buffing and belt polishing. Examples of a commercially available buffing apparatus include NT-700IM, manufactured by ISHIIHYOKI CO., LTD.

From the viewpoint of forming the conductive layer, the arithmetic mean roughness (Ra) of the polished surface of the magnetic layer is preferably 300 nm or more, more preferably 350 nm or more, and still more preferably 400 nm or more. The upper limit of the arithmetic mean roughness (Ra) is preferably 1000 nm or less, more preferably 900 nm or less, and still more preferably 800 nm or less. The surface roughness (Ra) can be measured using a non-contact type surface roughness meter, for example.

For the purpose of, for example, further enhancing the degree of cure of the magnetic layer, thermal treatment step may be performed, if needed, after the step (2) and before the step (4). It is sufficient that the temperature for the thermal treatment step is in accordance with the above-described curing temperature, and is preferably 120°C or higher, more preferably 130°C or higher, and still more preferably 150°C or higher, and preferably 240°C or lower, more preferably 220°C or lower, and still more preferably 200°C or lower. Time for the thermal treatment is preferably 5 minutes or longer, more preferably 10 minutes or longer, and still more preferably 15 minutes or longer, and preferably 90 minutes or shorter, more preferably 70 minutes or shorter, and still more preferably 60 minutes or shorter.

At the step (3), the polished surface of the magnetic layer 20A having been polished at the step (2) is subjected to desmearing. The execution of the step (3) allows a smear and the like generated at the step (2) to be removed.

A procedure and conditions at the roughening step are not particularly limited, and a well-known procedure and well-known conditions that are usually used in a method of manufacturing a multilayer printed wiring board can be employed. At the roughening step, for example, swelling treatment with a swelling solution, roughening treatment with an oxidant, and neutralization treatment with a neutralization solution are performed in this order, so that the magnetic layer 20A can be roughened.

Although the swelling solution to be used at the roughening step is not particularly limited, examples thereof include an alkali solution and a surfactant solution, and the swelling solution is preferably an alkali solution. The alkali solution serving as the swelling solution is more preferably a sodium hydroxide solution or a potassium hydroxide solution. Examples of a commercially available swelling solution include Swelling Dip Securiganth P and Swelling Dip Securiganth SBU, manufactured by Atotech Japan K. K.

The manner for the swelling treatment with the swelling solution is not particularly limited, but, the swelling treatment can be performed, for example, in such a manner that the core substrate 10 provided with the magnetic layer 20A is immersed in the swelling solution of 30°C to 90°C for 1 to 20 minutes. From the viewpoint of controlling the swelling of a resin constituting the magnetic layer 20A to within a suitable degree, the magnetic layer 20A is preferably immersed in the swelling solution of 40°C to 80°C for 5 to 15 minutes.

Although the oxidant to be used for the roughening treatment is not particularly limited, examples thereof include an alkaline permanganate solution in which potassium permanganate or sodium permanganate is dissolved in an aqueous solution of sodium hydroxide. The roughening by the use of the oxidant such as the alkaline permanganate solution is preferably performed in such a manner that, in an oxidant solution having been heated to 60°C to 80°C, the magnetic layer 20A is immersed for 10 to 30 minutes. The concentration of permanganate in the alkaline permanganate solution is preferably 5% by mass to 10% by mass. Examples of a commercially available oxidant include alkaline permanganate solutions, such as Concentrate Compact P and Dosing Solution Securiganth P, manufactured by Atotech Japan K. K.

The neutralization solution to be used for the neutralization treatment is preferably an acidic aqueous solution. Examples of a commercially available neutralization solution include Reduction Solution Securiganth P, manufactured by Atotech Japan K. K. The neutralization treatment with the neutralization solution can be performed in such a manner that a surface having been subjected to the roughening treatment by the use of the oxidant solution is immersed in the neutralization solution having 30°C to 80°C for 5 to 30 minutes. From the viewpoint of workability, the magnetic layer 20A having been subjected to the roughening treatment by the use of the oxidant solution is preferably immersed in the neutralization solution having 40°C to 70°C for 5 to 20 minutes.

The magnetic layer 20A is formed of the cured product of the magnetic paste of the present invention that is excellent in desmear resistance, and therefore has the property of having a low arithmetic mean roughness (Ra) of the surface of the cured product even when being subjected to desmearing. In other words, the resulting magnetic layer is excellent in desmear resistance and adhesion to the conductive layer. From the viewpoint of enhancing adhesion to plating, the arithmetic mean roughness (Ra) of the magnetic layer 20A after the desmearing is preferably 300 nm or more, more preferably 350 nm or more, and still more preferably 400 nm or more. The upper limit of the arithmetic mean roughness (Ra) is preferably less than 1000 nm, more preferably 700 nm or less, and still more preferably 650 nm or less. The surface roughness (Ra) can be measured, for example, using a non-contact type surface roughness meter.

At the step (4), a conductive layer is formed on the polished surface of the magnetic layer 20A. After the formation of the conductive layer, the conductive layer, the first metal layer 12, and the second metal layer 13 may be partially removed by etching or the like to form a pattern conductive layer, if needed.

Examples of a method for forming the conductive layer include plating, sputtering, and vapor deposition. Among these methods, plating is preferably used. In a preferable embodiment, a surface of the cured product is subjected to plating with an appropriate method, such as a semi-additive method or a full-additive method, to form a pattern conductive layer having a desired wiring pattern. Examples of a material of the conductive layer include single metals, such as gold, platinum, palladium, silver, copper, aluminum, cobalt, chromium, zinc, nickel, titanium, tungsten, iron, tin, and indium; and alloys of two or more kinds of metals selected from the group consisting of gold, platinum, palladium, silver, copper, aluminum, cobalt, chromium, zinc, nickel, titanium, tungsten, iron, tin, and indium. Among these metals, from the viewpoints of for example, versatility, cost, and ease of patterning, chromium, nickel, titanium, aluminum, zinc, gold, palladium, silver, copper, a nickel-chrome alloy, a copper-nickel alloy, or a copper-titanium alloy is preferably used. Chromium, nickel, titanium, aluminum, zinc, gold, palladium, silver, copper, or a nickel-chrome alloy is more preferably used. Copper is still more preferably used.

Here, an embodiment example in which the pattern conductive layer is formed on the polished surface of the cured product will be described in detail. A plating seed layer is formed on the polished surface of the cured product by non-electrolytic plating. Subsequently, an electrolytic plating layer is formed on the formed plating seed layer by electrolytic plating, and an unnecessary plating seed layer is removed by, for example, etching, if needed, so that a conductive layer having a desired circuit pattern can be formed. After the formation of the conductive layer, annealing treatment may be performed, if needed, for the purpose of, for example, enhancing the peel strength of the conductive layer. The annealing treatment can be performed by, for example, heating a circuit board at 150°C to 200°C for 20 to 90 minutes.

After the formation of the conductive layer, a mask pattern configured to cause a part of the plating seed layer to be exposed is formed on the formed plating seed layer so as to correspond to a desired wiring pattern. In this case, an electrolytic plating layer is formed on the exposed plating seed layer by electrolytic plating, and then the mask pattern is removed. Subsequently, an unnecessary part of the plating seed layer is removed by etching or the like to form a pattern conductive layer having a desired wiring pattern.

From the viewpoint of slimming down, the thickness of the pattern conductive layer is preferably 70 µm or less, more preferably 60 µm or less, still more preferably 50 µm or less, still more preferably 40 µm or less, and particularly preferably 30 µm or less, 20 µm or less, 15 µm or less, or 10 µm or less. The lower limit of the thickness is preferably 1 µm or more, more preferably 3 µm or more, and still more preferably 5 µm or more.

### Inductor substrate

An inductor substrate includes the circuit board of the present invention. Such inductor substrate has an inductor pattern formed of a conductor in at least a part of the periphery of the cured product of the magnetic paste. As such inductor substrate, for example, an inductor substrate described in Japanese Patent Application Laid-open No. 2016-197624 can be employed.

Such an inductor substrate can be used as a wiring board on which an electronic component, such as a semiconductor chip, is to be mounted, or the inductor substrate can be used as a (multilayer) printed wiring board that uses the wiring board as an inner layer substrate. Alternatively, the inductor substrate can be used as a chip inductor component obtained by making the wiring board into individual pieces, or can be used as a printed wiring board onto which the chip inductor component is surface-mounted.

Using the wiring board, various types of semiconductor devices can be produced. A semiconductor device including the wiring board can be preferably used for electrical products (for example, a computer, a cellular phone, a digital camera, and a television) and vehicles (for example, a motorcycle, an automobile, a train, a ship, and an airplane).

### Examples

Hereinafter, the present invention will be more specifically described using examples, but the present invention is not limited to these examples. Note that, in the following description, "part(s)" and "%" representing an amount mean "part(s) by mass" and "% by mass", respectively, unless otherwise specified.

### Example 1

12 parts by mass of an epoxy resin (ZX-1059, a mixed product of a bisphenol A epoxy resin and a bisphenol F epoxy resin, manufactured by NIPPON STEEL Chemical & Material Co., Ltd.), 5 parts by mass of a core-shell dispersion epoxy resin (MX-153, a bisphenol A epoxy resin containing an organic filler with a core-shell structure, having a content of the organic filler of 33% by mass and having an average particle diameter of 0.2 µm, manufactured by KANEKA CORPORATION), 5 parts by mass of a tri- or higher functional reactive diluent (EX-321L, aliphatic triglycidyl ether, manufactured by Nagase ChemteX Corporation), 1 part by mass of a dispersant (RS-710, a phosphate-based dispersant, manufactured by TOHO Chemical Industry Co., Ltd.), 1 part by mass of a curing agent (2MZA-PW, an imidazole-based curing accelerator, manufactured by SHIKOKU CHEMICALS CORPORATION), and 120 parts by mass of magnetic powder (M05S, Fe-Mn-based ferrite, having an average particle diameter of 3 µm, manufactured by Powdertech Co., Ltd.) were mixed and uniformly dispersed using a three-roll mill to prepare a magnetic paste 1.

### Example 2

A magnetic paste 2 was prepared in the same manner as in Example 1, except that,
the amount of the tri- or higher functional reactive diluent (EX-321L, aliphatic triglycidyl ether, manufactured by Nagase ChemteX Corporation) was changed from 5 parts by mass to 4 parts by mass, and
1 part by mass of a di- or lower functional reactive diluent (ZX-1658GS, cyclic aliphatic diglycidyl ether, manufactured by NIPPON STEEL Chemical & Material Co., Ltd.) was additionally used.

### Example 3

A magnetic paste 3 was prepared in the same manner as in Example 2, except that,
the amount of the di- or lower functional reactive diluent (ZX-1658GS, cyclic aliphatic diglycidyl ether, manufactured by NIPPON STEEL Chemical & Material Co., Ltd.) was changed from 1 part by mass to 2 parts by mass, and
the amount of the tri- or higher functional reactive diluent (EX-321L, aliphatic triglycidyl ether, manufactured by Nagase ChemteX Corporation) was changed from 4 parts by mass to 3 parts by mass.

### Example 4

A magnetic paste 4 was prepared in the same manner as in Example 2, except that,
the amount of the di- or lower functional reactive diluent (ZX-1658GS, cyclic aliphatic diglycidyl ether, manufactured by NIPPON STEEL Chemical & Material Co., Ltd.) was changed from 1 part by mass to 3 parts by mass, and
the amount of the tri- or higher functional reactive diluent (EX-321L, aliphatic triglycidyl ether, manufactured by Nagase ChemteX Corporation) was changed from 4 parts by mass to 2 parts by mass.

### Example 5

A magnetic paste 5 was prepared in the same manner as in Example 2, except that,
the amount of the di- or lower functional reactive diluent (ZX-1658GS, cyclic aliphatic diglycidyl ether, manufactured by NIPPON STEEL Chemical & Material Co., Ltd.) was changed from 1 part by mass to 4 parts by mass, and
the amount of the tri- or higher functional reactive diluent (EX-321L, aliphatic triglycidyl ether, manufactured by Nagase ChemteX Corporation) was changed from 4 parts by mass to 1 part by mass.

### Example 6

A magnetic paste 6 was prepared in the same manner as in Example 1, except that,
5 parts by mass of the tri- or higher functional reactive diluent (EX-321L, aliphatic triglycidyl ether, manufactured by Nagase ChemteX Corporation) was changed to 5 parts by mass of a tri- or higher functional reactive diluent (PETG, cyclic aliphatic tetraglycidyl ether), manufactured by Showa Denko K.K.).

### Example 7

A magnetic paste 7 was prepared in the same manner as in Example 1, except that,
the amount of the epoxy resin (ZX-1059, a mixed product of a bisphenol A epoxy resin and a bisphenol F epoxy resin, manufactured by NIPPON STEEL Chemical & Material Co., Ltd.) was changed from 12 parts by mass to 10 parts by mass, and
the amount of the tri- or higher functional reactive diluent (EX-321L, aliphatic triglycidyl ether, manufactured by Nagase ChemteX Corporation) was changed from 5 parts by mass to 7 parts by mass.

### Example 8

A magnetic paste 8 was prepared in the same manner as in Example 1, except that,
the amount of the epoxy resin (ZX-1059, a mixed product of a bisphenol A epoxy resin and a bisphenol F epoxy resin, manufactured by NIPPON STEEL Chemical & Material Co., Ltd.) was changed from 12 parts by mass to 3 parts by mass, and
the amount of the tri- or higher functional reactive diluent (EX-321L, aliphatic triglycidyl ether, manufactured by Nagase ChemteX Corporation) was changed from 5 parts by mass to 14 parts by mass.

### Comparative Example 1

A magnetic paste 9 was prepared in the same manner as in Example 2, except that,
the amount of the di- or lower functional reactive diluent (ZX-1658GS, cyclic aliphatic diglycidyl ether, manufactured by NIPPON STEEL Chemical & Material Co., Ltd.) was changed from 1 part by mass to 5 parts by mass, and
4 parts by mass of the tri- or higher functional reactive diluent (EX-321L, aliphatic triglycidyl ether, manufactured by Nagase ChemteX Corporation) was not used.

### Comparative Example 2

A magnetic paste 10 was prepared in the same manner as in Example 6, except that,
5 parts by mass of the tri- or higher functional reactive diluent (PETG, cyclic aliphatic tetraglycidyl ether), manufactured by Showa Denko K.K.) was changed to 5 parts by mass of a di- or lower functional reactive diluent (EX-201L, cyclic aliphatic diglycidyl ether, manufactured by Nagase ChemteX Corporation).

### Measurement of relative magnetic permeability and magnetic loss

As a support, a polyethylene terephthalate (PET) film (PET501010, manufactured by LINTEC Corporation, 50 µm in thickness) having been subjected to treatment with a silicone-based mold-release agent was prepared. Each of the magnetic pastes 1 to 10 prepared respectively in Examples and Comparative Examples was uniformly applied onto a release surface of the PET film by a doctor blade so as to achieve a paste layer thickness of 100 µm after drying, whereby a resin sheet was obtained. The obtained resin sheet was heated at 190°C for 90 minutes to thermal-cure a paste layer, and the support was detached from the resin sheet to obtain a cured product in a sheet form. The obtained cured product was cut into a test piece having a width of 5 mm and a length of 18 mm to obtain an evaluation sample. The relative magnetic permeability (µ') and the magnetic loss (µ'') of the evaluation sample were measured at a room temperature of 23°C and a measurement frequency of 100 MHz by a three-turn coil method using HP8362B (manufactured by Agilent Technologies, Ltd).

### Evaluation of peel strength

Both surfaces of a double-sided copper clad laminate with an epoxy resin-glass cloth base material (R5715ES, manufactured by Panasonic Corporation, having a copper foil thickness of 18 µm and a substrate thickness of 0.3 mm) were etched to a depth of 1 µm by using a micro-etching agent (CZ8100, manufactured by MEC COMPANY LTD.), whereby the copper surfaces were roughened to prepare an inner layer substrate.

Each of the magnetic pastes 1 to 10 prepared respectively in Examples and Comparative Examples was uniformly applied onto the inner layer substrate by a doctor blade so as to achieve a paste layer thickness of 50 µm after drying, whereby a paste layer was formed. The paste layer was heated at 130°C for 30 minutes and furthermore heated at 150°C for 30 minutes to be thermally-cured, whereby a cured product layer was formed. A surface of the formed cured product layer was subjected to buffing, and then subjected to thermal treatment by heating at 180°C for 30 minutes.

The surface of the cured product layer having been subjected to the thermally treatment was immersed at 60°C for 5 minutes in a swelling solution, namely, Swelling Dip Securiganth P(an aqueous solution of glycol ethers and sodium hydroxide), containing diethylene glycol monobutyl ether and manufactured by Atotech Japan K. K. Next, the surface of the cured product layer was immersed in a roughening solution, namely, Concentrate Compact P (an aqueous solution of 60 g/L of KMnO₄ and 40 g/L of NaOH), manufactured by Atotech Japan K. K., at 80°C for 5 minutes. Finally, the surface of the cured product layer was immersed in a neutralization solution, namely, Reduction Solution Securiganth P (an aqueous solution of sulfuric acid), manufactured by Atotech Japan K. K., at 40°C for 5 minutes. Subsequently, the surface of the cured product layer was dried at 40°C to obtain a laminate A.

The laminate A was immersed in a PdCl₂-containing non-electrolytic plating solution at 40°C for 5 minutes, and then immersed in a non-electrolytic copper plating solution at 25°C for 20 minutes. After the laminate A was heated for annealing treatment at 150°C for 30 minutes, an etching resist was formed. After patterning by etching, the laminate A was subjected to electrolytic plating with copper sulfate to form a conductive layer having a thickness of 25 µm. Subsequently, the laminate A was subjected to annealing treatment at 180°C for 60 minutes. The resulting substrate was taken as an evaluation substrate.

A cut having a width of 10 mm and a length of 100 mm was made in the conductive layer of the evaluation substrate, and one end thereof was peeled, and grasped by a grasping tool (an autocom type testing instrument, AC-50C-SL, manufactured by TSE Co., Ltd.), and a load (kgf/cm) at the time of peeling to an extent of 35 mm in a vertical direction at a speed of 50 mm/min at room temperature was measured. In the case where the measurement of the load of an evaluation substrate was successfully made, the evaluation substrate was rated as "O". On the other hand, in the case where a blister developed in the conductive layer after the electrolytic plating treatment of an evaluation substrate and accordingly peel strength could not be measured, the evaluation substrate was rated as "×".

Measurement of Arithmetic Mean Roughness (Ra Value)

An Ra value of the laminate A was determined from numerical values obtained in a measurement region of 121 µm × 92 µm by the use of a non-contact type surface roughness meter (WYKO NT3300, manufactured by Veeco Instruments Inc.) in a VSI mode with a 50× lens. The Ra value was measured by determining the average of values obtained at 3 points chosen at random, and evaluated on the following criteria.
O: Ra value of 700 nm or less
Δ : Ra value of more than 700 nm and less than 1000 nm
×: Ra value of 1000 nm or more

**Table 1**

| (Table 1) | | | | | | | | | | | | |
|---|---|---|---|---|---|---|---|---|---|---|---|---|
| | | | Example | | | | | | | | Comparative Example | |
| | | | 1 | 2 | 3 | 4 | 5 | 6 | 7 | 8 | 1 | 2 |
| Component (A) | | M05S | 120 | 120 | 120 | 120 | 120 | 120 | 120 | 120 | 120 | 120 |
| Component (B) | | ZX-1059 | 12 | 12 | 12 | 12 | 12 | 12 | 10 | 3 | 12 | 12 |
| | | MX-153 | 5 | 5 | 5 | 5 | 5 | 5 | 5 | 5 | 5 | 5 |
| Component (C) | di- or lower functional reactive diluent | ZX-1658GS | | 1 | 2 | 3 | 4 | | | | 5 | |
| | | EX-201 | | | | | | | | | | 5 |
| | tri- or higher functional reactive diluent | EX-321 L | 5 | 4 | 3 | 2 | 1 | | 7 | 14 | | |
| | | PETG | | | | | | 5 | | | | |
| Component (D) | | 2MZA-PW | 1 | 1 | 1 | 1 | 1 | 1 | 1 | 1 | 1 | 1 |
| Component (E) | | RS-710 | 1 | 1 | 1 | 1 | 1 | 1 | 1 | 1 | 1 | 1 |
| Total amount (part by mass) | | | 144 | 144 | 144 | 144 | 144 | 144 | 144 | 144 | 144 | 144 |
| Ra (nm) | | | O | O | O | Δ | Δ | O | O | Δ | × | × |
| | | | 600 | 600 | 650 | 800 | 900 | 600 | 700 | 900 | 1050 | 1100 |
| Peel strength (kgf/cm) | | | O | O | O | O | O | O | O | O | × | × |
| | | | 0.23 | 0.23 | 0.2 | 0.18 | 0.15 | 0.25 | 0.17 | 0.18 | | |
| Relative magnetic permeability (100 MHz) | | | 6.8 | 6.7 | 6.6 | 6.7 | 6.7 | 6.5 | 6.8 | 6.8 | 6.7 | 7 |
| Magnetic loss (100 MHz) | | | 0.12 | 0.12 | 0.10 | 0.18 | 0.11 | 0.09 | 0.12 | 0.12 | 0.12 | 0.18 |

It was found that Examples 1 to 8 were excellent in desmear resistance, and therefore, even when Examples 1 to 8 were subjected to desmearing, Ra values thereof could be kept low. On the other hand, it was found that Comparative Examples 1 and 2 were inferior in desmear resistance to Examples 1 to 8, and therefore, when Comparative Examples 1 and 2 were subjected to desmearing, resin components of the magnetic layer were peeled off or dissolved, so that Ra values of Comparative Examples 1 and 2 were higher than those of Examples 1 to 8. Furthermore, it was found that Examples 1 to 8 were excellent in desmear resistance, and therefore, even when a conductive layer was formed after desmearing, a blister could be substantially prevented from developing in the conductive layer, and as a result, peel strength between the magnetic layer and the conductive layer was enhanced.

It has been confirmed that, in Examples 1 to 8, even in the case where the component (E) is not contained, the same results as in the above-mentioned Examples can be obtained to a greater or lesser degree.

## Claims

1. A magnetic paste comprising:
magnetic powder (A);
an epoxy resin (B);
a reactive diluent (C); and
a curing agent (D), wherein
the reactive diluent (C) includes a tri- or higher functional reactive diluent.

2. The magnetic paste according to claim 1, wherein a content of the tri- or higher functional reactive diluent is 0.5% by mass or higher and 10% by mass or lower, with respect to 100% by mass of non-volatile components in the magnetic paste.

3. The magnetic paste according to claim 1 or 2, wherein a content of the tri- or higher functional reactive diluent is 20% by mass or higher, with respect to 100% by mass of an entirety of the reactive diluent (C).

4. The magnetic paste according to any one of claims 1 to 3, wherein the magnetic powder (A) is soft magnetic powder.

5. The magnetic paste according to any one of claims 1 to 4, wherein the magnetic powder (A) is iron oxide powder.

6. The magnetic paste according to claim 5, wherein the iron oxide powder is ferrite containing at least one selected from Ni, Cu, Mn, and Zn.

7. The magnetic paste according to any one of claims 1 to 6, wherein the magnetic powder (A) is at least one selected from Fe-Mn-based ferrite and Fe-Mn-Zn-based ferrite.

8. The magnetic paste according to any one of claims 1 to 7, wherein a content of the magnetic powder (A) is 60% by mass or higher with respect to 100% by mass of non-volatile components in the magnetic paste.

9. The magnetic paste according to any one of claims 1 to 8, the magnetic paste is for through-hole filling.

10. A circuit board comprising a substrate having a through-hole filled with a cured product of the magnetic paste according to any one of claims 1 to 9.

11. An inductor component comprising the circuit board according to claim 10.

12. A method for manufacturing a circuit board, the method comprising:
(1) filling a through-hole with a magnetic paste and thermally curing the magnetic paste to obtain a cured product;
(2) polishing a surface of the cured product;
(3) desmearing the polished surface of the cured product; and
(4) forming a conductive layer in the polished surface of the cured product, wherein
the magnetic paste is the magnetic paste according to any one of claims 1 to 9.
